# EUROPEAN PATENT APPLICATION

(11) **EP 1 962 321 A1**
(43) Date of publication of application: **27.08.2008**
(21) Application number: 08100091.1
(22) Date of filing: 04.01.2008
(51) Int. Cl.: H01J 37/32

(54) **Plasma gun**

(30) Priority: 22.02.2007 KR 20070018088
(71) Applicant: Samsung SDI Co., Ltd., Suwon-si Gyeonggi-do (KR)
(72) Inventor: Choi, Yong-Sup Samsung SDI Co.,Ltd., Gyeonggi-do (KR); Kim, Jin-Pil Samsung SDI Co., Ltd., Gyeonggi-do (KR); Lee, Kang-Il Samsung SDI Co., Ltd., Gyeonggi-do (KR)
(74) Representative: Hengelhaupt, Jürgen

(57) **Abstract**

Provided is a plasma gun 9 including: a cathode unit 20 generating plasma 6; and a return electrode unit 90 which ejects the plasma 6 generated in the cathode unit 20 toward a target and returns electrons reflected from the target to a power source. The return electrode unit 90 includes a frame 1e, an insulating tube 1h, and a gas flow means 91, 92, 93. The frame 1e includes a plasma outlet. The insulating tube 1h electrically insulates the surface of the plasma outlet. The gas flow means 91, 92, 93 are adapted to eject gases toward a target side end of the insulating tube 1h.

## Description

### BACKGROUND OF THE INVENTION

### Field of the Invention

The present invention relates to a plasma gun, and more particularly, to a plasma gun including a cathode unit generating plasma, and a return electrode unit which ejects plasma generated in the cathode unit toward a target and returns electrons reflected from the target, such as a deposition chamber, to a power source.

### Description of the Related Art

Plasma guns are widely used in a thin film deposition device, for example in a thin film deposition device for deposition of MgO during plasma display panel manufacture. An example of the thin film deposition device is a device for vapour deposition of MgO on the plasma display panel disclosed in Korean Patent Publication No. 2001-25739.

A thin film deposition device employs a plasma gun. The plasma gun is combined with a deposition chamber in a conventional thin film deposition device.

In the deposition chamber, a deposition material is placed on a hearth electrode. A deposition target is installed to face the hearth electrode. Further, discharge gases and gases controlling reactions such as oxygen (O₂) and hydrogen (H₂) are injected through gas inlets.

A conventional plasma gun includes a cathode unit, a first grid, a second grid, and a return electrode unit. Spaces between the first grid and the second grid, and between the second grid and the return electrode unit are sealed by a vacuum seal-ring.

The cathode unit generates plasma. The first grid and the second grid control flow rate of plasma between the cathode unit and the return electrode unit. The return electrode unit ejects plasma generated in the cathode unit toward a target and returns electrons reflected from the target. The return electrode unit includes a frame and an insulating tube. A plasma outlet is formed in the centre of the frame. The insulating tube electrically insulates the surface of the plasma outlet.

Main plasma ejected straight and branched plasma ejected to the outside surface of the frame of the return electrode unit coexist at the outlet of the return electrode unit. The plasma may be branched since main components of the plasma are thermal electrons and straight polarity is applied to the frame of the return electrode unit. Accordingly, the insulating tube of the return electrode unit can be gradually burned since it is heated by the branched plasma.

### SUMMARY OF THE INVENTION

It is therefore on object of the present invention to provide an improved plasma gun.

It is another object to provide a plasma gun which prevents damage from occurring in an insulating tube included in a return electrode unit since the insulating tube is heated by the branched plasma and gradually burned.

According to an the present invention, there is provided a plasma gun including: a cathode unit adapted to generate a plasma; and a return electrode unit adapted to eject the plasma generated in the cathode unit toward a target and to return electrons reflected from the target to a power source. The return electrode unit includes a frame, an insulating tube, and gas flow means. The frame and the insulating tube comprise a target side end that is directed to the target and a cathode side end that is directed to the cathode unit.

The frame includes a plasma outlet. The insulating tube electrically insulates the surface of the plasma outlet. The gas flow means is formed to eject gases toward a target side end of the insulating tube. The gas flow means are adapted to eject gases toward the target side end of the insulating tube.

According to a preferred embodiment of the invention the gas flow means comprise a plurality of gas ejection paths formed in a region of the inside surface of the frame and being connected with the outside of the frame to eject gases passing through the frame toward the target side end of the insulating tube. Preferably, the plurality of gas ejection paths being arranged in a circular manner around the target side end of the insulating tube.

It is further preferred that the gas flow means further comprising a cover having at least one hole connected to the plasma outlet and attached to the inside surface of the frame of the return electrode unit to form a flow channel on an inside surface of the frame, the flow channel being connected with the plurality of gas ejection paths.

According to another embodiment of the invention, the gas flow means further comprise at least one a gas injection path passing through the frame from the outside of the frame to the flow channel formed by the cover. Preferably, the plurality of gas ejection paths that are formed in a region of the inside surface of the frame are covered by the cover at the cathode side end of the frame.

According to the plasma gun, gases such as oxygen (O₂) or hydrogen (H₂) which are used in a target such as a thin film deposition device can be ejected toward the target side end of an insulating tube through the gas flow means formed in the return electrode unit. Accordingly, branched plasma that is ejected from the target side end of the insulating tube in a direction of surrounding the insulating tube collides with gases ejected from the gas flow means, and thus loses its energy. As a result, damages are prevented which occur in the conventional insulating tubes due to the heating by the branched plasma and the gradual burning of the insulating tube.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is a cross-sectional view of a thin film deposition device employing a plasma gun;
FIG. 2 is a cross-sectional view illustrating an enlarged conventional plasma gun;
FIG. 3 is a cross-sectional view of the second grid and the return electrode unit illustrating_a direction of plasma ejected from the plasma gun of FIG. 2;
FIG. 4 illustrates a clean insulating tube of a plasma gun;
FIG. 5 illustrates an insulating tube gradually burned by plasma ejected with the apparatus illustrated in FIG. 3;
FIG. 6 is an exploded perspective view of a return electrode unit of a plasma gun constructed as to an embodiment of the principles of the present invention; and
FIG. 7 is a cross-sectional view of a plasma gun employing the return electrode unit shown in FIG. 6.

### DETAILED DESCRIPTION OF THE INVENTION

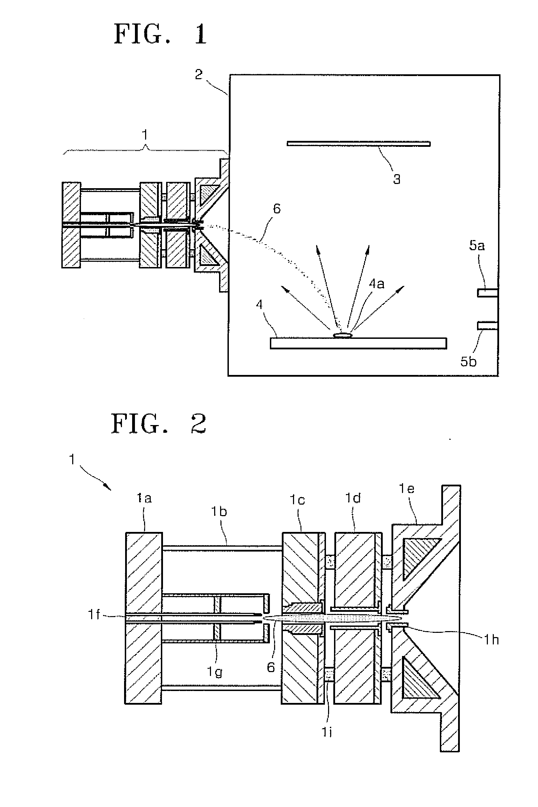

FIG. 1 is a cross-sectional view of a thin film deposition device employing a plasma gun. Referring to FIG. 1, a plasma gun 1 is combined with a deposition chamber 2 in a conventional thin film deposition device.

In deposition chamber 2, a deposition material 4a such as MgO is placed on a hearth electrode 4. A deposition target 3 such as a substrate is installed to face the hearth electrode 4. Further, discharge gases and gases controlling reactions such as oxygen (O₂) and hydrogen (H₂) are injected through gas inlets 5a and 5b.

A plasma 6 ejected from the plasma gun 1 transmits energy to the deposition material 4a such as MgO placed on the hearth electrode 4, and accordingly the deposition material 4a is evaporated to be attached to the deposition target 3.

Referring to FIG. 2, a conventional plasma gun 1 includes a cathode unit 20, a first grid 1c, a second grid 1d, and a return electrode unit 10. The cathode unit 20 is sealed by a quartz tube 1b. Spaces between the first grid 1c and the second grid 1d, and between the second grid 1d and the return electrode unit 10 are sealed by a vacuum seal-ring 1i.

The cathode unit 20 generates plasma 6. The first grid 1c and the second grid 1d control flow rate of the plasma 6 between the cathode unit 20 and the return electrode unit 10. The return electrode unit 10 ejects the plasma 6 generated in the cathode unit 20 toward a target and returns electrons reflected from the target, for example, the deposition chamber 2 of FIG. 1 to a power source.

The cathode unit 20 includes a frame 1a, a discharge gas inlet 1f, and an electron emitting source 1g such as LaB₆. A discharge gas such as Ar gas injected from the discharge gas inlet 1f collides with primary electrons by electric fields to be ionised. The ionised discharge gas collides with the electron emitting source 1g to generate plasma 6 containing thermal electrons.

The plasma 6 generated in the cathode unit 20 is accelerated by the first grid 1c and the second grid 1d and enters a target, for example, the deposition chamber 2 of FIG. 1 through the return electrode unit 10.

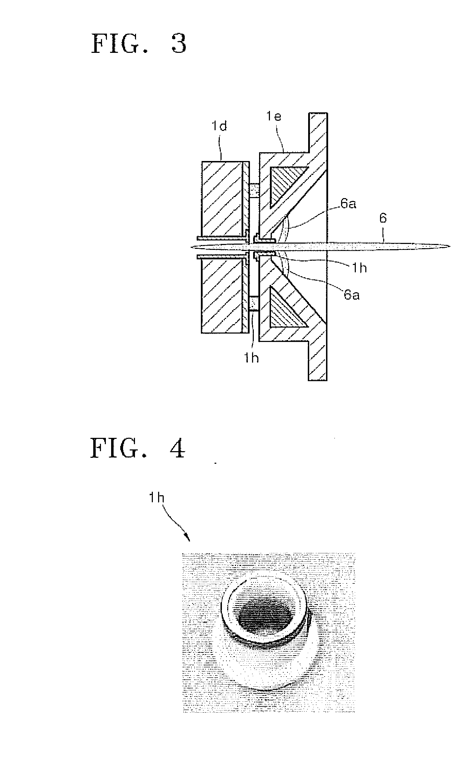

The return electrode unit 10 includes a frame 1e and an insulating tube 1h. A plasma outlet is formed in the center of the frame 1e. The insulating tube 1h electrically insulates the surface of the plasma outlet (FIG. 4).

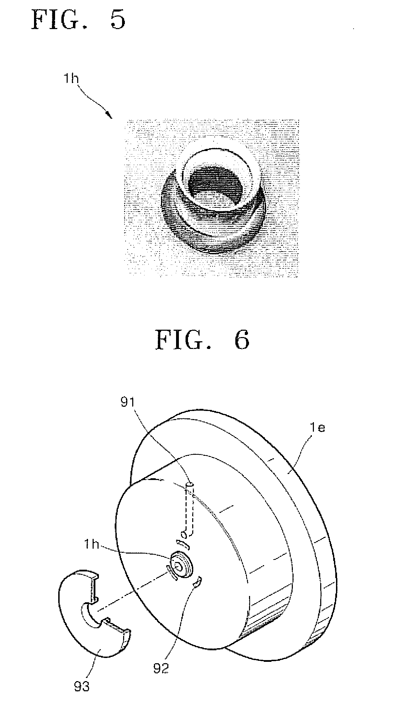

FIG. 3 is a cross-sectional view of the second grid and the return electrode unit 10 to explain a direction of plasma ejected from the plasma gun of FIG. 2. FIG. 4 illustrates a clean insulating tube 1h of FIG. 3 of a plasma gun. FIG. 5 illustrates an insulating tube 1h gradually burned by plasma ejected as illustrated in FIG. 3.

Referring to FIGS. 3 to 5, main plasma 6 ejected straight and a branched plasma 6a ejected to the outside surface of the frame 1e of the return electrode unit 10 coexist at the outlet of the return electrode unit 10. The plasma may be branched since main components of the plasma 6 and 6a are thermal electrons and straight polarity is applied to the frame 1e of the return electrode unit 10.

Accordingly, the clean insulating tube 1h of the return electrode unit 10 in FIG. 4 can be gradually burned since it is heated by the branched plasma 6a (FIG. 5).

The present invention will now be described more fully with reference to the accompanying drawings, in which exemplary embodiments of the invention are shown. Since the same target, such as the deposition chamber, of the plasma gun described with reference to FIG. 1 is used herein, and thus description thereof is omitted.

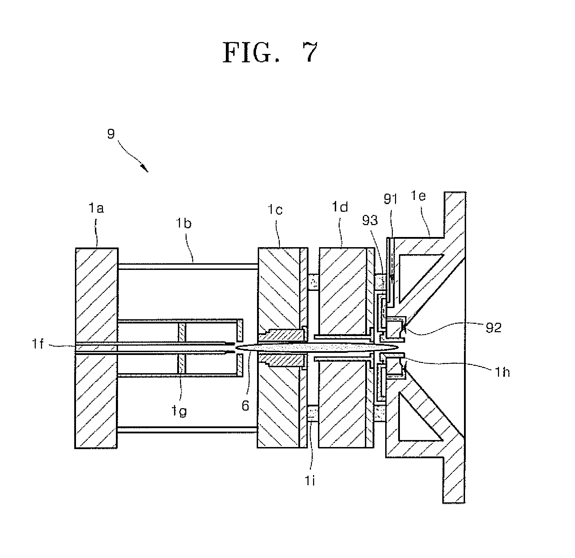

FIG. 6 is an exploded perspective view of a return electrode unit 90 of a plasma gun 9 of FIG. 7 according to an embodiment of the present invention. FIG. 7 is a cross-sectional view of the plasma gun 9 employing the return electrode unit 90 of FIG. 6. Referring to FIGS. 6 and 7, the plasma gun 9 will now be described.

The plasma gun 9 according to an embodiment of the present invention includes a cathode unit 20, a first grid 1c, a second grid 1d, and the return electrode unit 90. The cathode unit 20 is sealed by a quartz tube 1b. Spaces between the first grid 1c and the second grid 1d, and between the second grid 1d and the return electrode unit 90 are sealed by a vacuum seal-ring 1i.

The cathode unit 20 generates plasma 6. the first grid 1c and the second grid 1d control the flow rate of the plasma 6 between the cathode unit 20 and the return electrode unit 90. The return electrode unit 90 ejects the plasma 6 generated in the cathode unit 20 toward a target and returns electrons reflected from the target, for example the deposition chamber 2 of FIG. 1 to a power source.

The cathode unit 20 includes a frame 1a, a discharge gas inlet 1f, and an electron emitting source 1g such as LaB₆. The discharge gas such as Ar gas injected from the discharge gas inlet lf collides with primary electrons by electric fields to be ionised. The ionised discharge gas collides with the electron emitting source 1g to generate plasma containing thermal electrons.

The plasma generated in cathode unit 20 is accelerated by the first grid 1c and the second grid 1d and enters a target, for example, the deposition chamber 2 of FIG. 1 through the return electrode unit 90.

The return electrode unit 90 includes a frame 1e, an insulating tube 1h, and gas flow means 91, 92, and 93. A plasma outlet is formed in the centre of the frame 1e. The insulating tube 1h electrically insulates the surface of the plasma outlet (FIG. 4).

The gas flow means 91, 92, and 93 are formed to eject gases toward a target side end (a direction depicted as a dotted line) of the insulating tube 1h. For example, gases such as oxygen (O₂) or hydrogen (H₂) which are injected into the target such as the thin deposition device (FIG. 1) through the gas flow means 91, 92, and 93 are ejected toward the target side end (the direction depicted as a dotted line) of the insulating tube 1h. Accordingly, the branched plasma 6a of FIG. 3 that is ejected from the target side end of the insulating tube 1h in a direction of the surrounding insulating tube 1h collides with gases ejected from the gas flow means 91, 92, and 93, and thus loses its energy. As a result, damages occurring in the conventional insulating tube 1h since the insulating tube is heated by branched plasma 6a of FIG. 3 and gradually burned are prevented.

The gas flow means 91, 92, and 93 include a cover 93, a gas injection path 91, and a plurality of gas ejection paths 92.

The cover 93 comprises holes connected to the plasma outlet and is attached to the inside surface of the frame 1e by the holes to form a flow channel on the inside surface of the frame 1e.

The gas injection path 91 passes through the frame 1e from the outside of the frame 1e to the flow channel.

The plurality of gas ejection paths 92 is formed in a region of the inside surface of the frame 1e which is covered by the cover 93 to eject gases which pass through the frame 1e from the flow channel toward a target side end of the insulating tube 1h.

Accordingly, when gases such as oxygen (O₂) or hydrogen (H₂) which are used in the thin film deposition device (FIG. 1) are injected into the gas injection path 91, the injected gases are ejected toward the target side end of the insulating tube 1h through the gas injection path 91, the cover 93, the flow channel formed by the cover 93, and the plurality of gas ejection paths 92.

According to the gas flow means 91, 92, and 93, a plurality of gas ejection paths 92 can be formed in a narrow area by using the gas injection path 91 and the cover 93.

As described above, in a plasma gun according to the present invention, gases such as oxygen (O₂) or hydrogen (H₂) which are used in a target such as a thin film deposition device can be ejected toward the target side end of an insulating tube through a gas flow means formed in a return electrode unit. Accordingly, branched plasma that is ejected from the target side end of the insulating tube in a direction of surrounding the insulating tube collides with gases ejected from the gas flow means, and thus lose its energy. As a result, damages occurred in the insulating tube since the insulating tube is heated by the branched plasma and gradually burned may be prevented.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A plasma gun (9) comprising:
a cathode unit (20) adapted to generate a plasma (6); and
a return electrode unit (90) adapted to eject the plasma (6) generated in the cathode unit (20) toward a target and to return electrons reflected from the target to a power source,
with the return electrode unit (90) comprising a frame (1e) having a plasma outlet, an insulating tube (1h) electrically insulating the surface of the plasma outlet, the insulating tube (1h) comprising a target side end and a cathode side end,
**characterised in, that**
the return electrode unit (90) further comprises gas flow means (91, 92, 93) adapted to eject gases toward the target side end of the insulating tube (1h).

2. The plasma gun (9) of claim 1, with the gas flow means (91, 92, 93) comprising a plurality of gas ejection paths (92) formed in a region of the inside surface of the frame (1e) and being connected with the outside of the frame (1e) to eject gases passing through the frame toward the target side end of the insulating tube (1h).

3. The plasma gun (9) of claim 2, with the plurality of gas ejection paths (92) being arranged in a circular manner around the target side end of the insulating tube (1h).

4. The plasma gun (9) of claim 2 or 3, with the gas flow means (91, 92, 93) further comprising a cover (93) having at least one hole connected to the plasma outlet and attached to the inside surface of the frame (1e) of the return electrode unit (90) to form a flow channel on an inside surface of the frame (1e), the flow channel being connected with the plurality of gas ejection paths (92).

5. The plasma gun (9) of claim 4, with the gas flow means (91, 92, 93) further comprising at least one a gas injection path (91) passing through the frame (le) from the outside of the frame (le) to the flow channel formed by the cover (93).

6. The plasma gun (9) of claims 4 and 5, with the plurality of gas ejection paths (92) formed in a region of the inside surface of the frame (le) are covered by the cover (93) at the cathode side end of the frame (le).

7. The plasma gun (9) of one of the preceding claims, further comprising a first grid (1c) and a second grid (1d) to control a flow rate of the plasma (6) between the cathode unit (20) and the return electrode unit (90).

8. The plasma gun (9) of one of the preceding claims, with the cathode unit (20) comprising an inlet (1f) of discharge gas ionised by electric fields, and an electron emitting source (1g) colliding with the ionised discharge gas to generate thermal electrons.
